# EUROPÄISCHE PATENTSCHRIFT

(11) **EP 0 715 745 B1**
(45) Veröffentlichungstag und Bekanntmachung des Hinweises auf die Patenterteilung: **17.04.2002**
(21) Anmeldenummer: 94924700.1
(22) Anmeldetag: 27.08.1994
(51) Int. Cl.: G08B 21/00, G01R 19/165

(54) **VORRICHTUNG ZUR ANSTEUERUNG EINER WARNEINRICHTUNG**
DEVICE FOR TRIGGERING A WARNING DEVICE
DISPOSITIF DE DECLENCHEMENT D'UN SYSTEME DE DETRESSE

(30) Priorität: 01.09.1993 DE 9313129 U; 22.11.1993 DE 9317810 U
(43) Veröffentlichungstag der Anmeldung: 12.06.1996
(73) Patentinhaber: ROBERT BOSCH GMBH, 70442 Stuttgart (DE)
(72) Erfinder: KÜHNER, Karl-Friedrich, D-74360 Ilsfeld (DE); BEITLER, Thomas, D-73207 Plochingen (DE); SCHNEIDER, Thomas, D-71706 Markgröningen (DE); WALTER, Gerhard, D-70839 Gerlingen (DE)
(86) Internationale Anmeldenummer: DE9400992
(87) Internationale Veröffentlichungsnummer: WO9506928

(56) Entgegenhaltungen:
- EP-A- 0 009 649
- GB-A- 2 042 193
- PATENT ABSTRACTS OF JAPAN vol. 4, no. 32 (E-2) (514) 19. März 1980 & JP,A,55 004 117 (MITSUBISHI) 12. Januar 1980
- ELECTRONIC ENGINEERING, Bd.55, Nr.684, Dezember 1983, LONDON Seite 26 J. BUTTON 'WINDOW DETECTORS AND INDICATORS'

## Beschreibung

### Stand der Technik

In Kraftfahrzeugen werden häufig Regler mitgeführt, die abhängig vom Verhalten der Fahrzeugräder und/oder des Fahrzeugs den Bremsdruck und/oder das Motormoment und/oder die Lenkung beeinflussen. Ein solcher Regler kann z.B. ein Antiblockierregelsystem, ein Antriebsschlupfregler oder ein Fahrdynamikregler sein.

Bei derartigen Reglern ist im Sichtfeld des Fahrers eine Warneinrichtung, z.B. eine Sicherheitslampe angeordnet, die im Falle eines Fehlers im Regler, der möglicherweise auch die Abschaltung des Reglers zur Folge hat, durch das Steuergerät des Reglers an Masse gelegt wird. Damit wird der Fehler angezeigt und der Fahrer gewarnt.

Aus dem Zeitschriftenartikel ELECTRONIC ENGINEERING, Bd. 55, Nr. 684, Dezember 1983, London, Seite 26, J. Button Window Detectors and Indiactors ist ein sogenannter Fensterkomparator bekannt, bei dem das Ausgangssignal nur dann einen hohen Pegel annimmt, wenn das Eingangssignal zwischen einem ersten Wert VL und einem zweiten Wert VU liegt. Die Figur 2 des Dokumentes D1 zeigt eine Variante, bei der mittels Leuchtdioden angezeigt wird, ob das Signal normal, zu hoch und/oder zu niedrig ist.

Aus der GB-A-2042 193 ist eine Vorrichtung zur Überwachung von Glühkerzen bekannt. Weicht die Spannung, die an den Glühkerzen abfällt, von einem erwarteten Wert nach oben und/oder nach unten ab, so wird dies mittels einer Lampe angezeigt. Hierzu ist an einen Vergleicher einerseits eine Vergleichsspannung und andererseits die Spannung an den Glühkerzen anlegbar. Der Vergleicher steuert die Lampe an, wenn die Spannung an den Glühkerzen kleiner als eine erste Vergleichsspannung und/oder wenn die Spannung an den Glühkerzen größer als die Vergleichsspannung ist.

Aus der EP 0 009 649 ist eine Vorrichtung zur Überwachung von Schaltzuständen einer Mehrspannungswähleinrichtung in Reisewagen, die im internationalen Zugverkehr verwendet werden, bekannt. Hierzu wird ein Strom über einen Meßwiderstand geführt und die am Meßwiderstand abfallende Spannung mit Vergleichern ausgewertet.

### Vorteile der Neuerung

Bei der Neuerung wird der Abriß der Steuergerätemasse angezeigt und in der Ausbildung des Anspruchs 2 wird zusätzlich die Ansteuerleitung für die Sicherheitslampe überwacht.

### Zeichnung

Die Erfindung, die in Anspruch 1 definiert ist, wird nachstehend anhand der in der Zeichnung dargestellten Ausführungsform erläutert. Es zeigen Figur 1 eine nicht erfindungsgemäße Anordnung, Figur 2 eine Ausführungsform der Erfindung und Figur 3 verschiedene über der Zeit aufgetragene Signale.

### Figurenbeschreibung

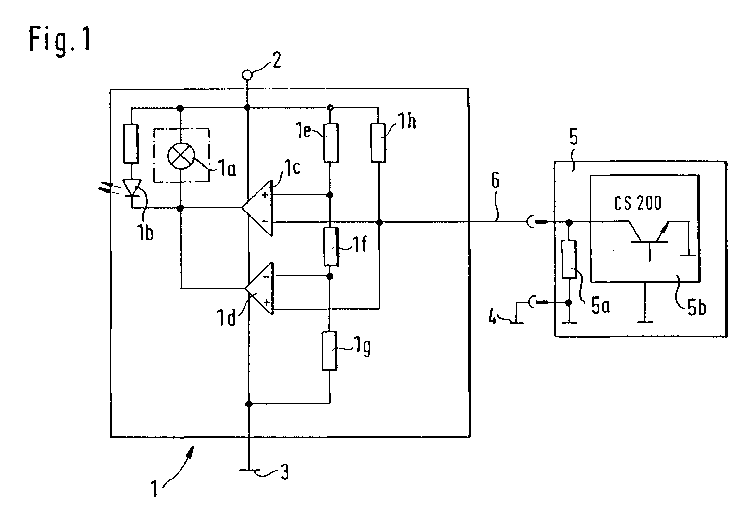

Anhand der Figur 1 werden einige Aspekte der Neuerung beschrieben. Ein Block 1 ist in der Nähe des Fahrers z.B. im Armaturenbrett untergebracht. Er enthält eine Warneinrichtung, die als Sicherheitslampe 1a oder als Sicherheitsleuchtdiode 1b realisiert sein kann. Der Block 1 enthält weiterhin zwei Vergleichsmittel 1c und 1d. An einer Klemme 2 liegt Versorgungsspannung an. Hierbei handelt es sich vorzugsweise um die über die Zündung anliegende Batteriespannung.

Ferner weist der Block 1 einen Masseanschluß 3 auf. Zwischen der Klemme 2 und dem Masseanschluß 3 liegt ein erster Spannungsteiler bestehend aus den Widerständen 1e (z.B. 10 kΩ), 1f (z.B. 10 kΩ) und 1g (z.B. 10 kΩ); hierüber werden die Vergleicher 1c und 1d mit Vergleichsspannungen versorgt. Zwischen der Klemme 2 und dem Masseanschluß 4 eines entfernt angeordneten Steuergeräts 5 liegt ein zweiter Spannungsteiler mit Widerständen 1h (z.B. 2 kΩ) und 5a (z.B. 2 kΩ). Dieser Spannungsteiler nutzt die Masse 4 des Steuergeräts 5.

Über einen Schalter 5b kann das Steuergerät über den Vergleicher 1d Massepotential an die Sicherheitslampe anlegen, wenn dem Fahrer ein Fehler des Reglers anzuzeigen ist.

An den Vergleicher wird einerseits eine Vergleichsspannung, die von dem ersten Spannungsteiler bereitgestellt wird, und andererseits eine weitere Spannung, die von dem zweiten Spannungsteiler bereitgestellt wird, angelegt. Der Vergleicher schaltet, die an ihm anliegende Masse, an die Warneinrichtung durch, wenn die weitere Spannung kleiner als eine erste Vergleichsspannung und/oder größer als eine zweite Vergleichsspannung ist.

Die Spannungen am Vergleicher sind dabei derart gewählt, daß die Vergleicher bei Abreißen der Masse, beim Bruch der Ansteuerleitung zwischen Steuergerät und Sicherheitslampe und/oder bei Bruch der Versorgungsleitungen des Steuergeräts durchschalten und die an ihnen anliegende Masse an die Warneinrichtung anlegen.

Reißt der Masseanschluß 4 ab, dann ändert sich die Spannung am unteren (-) Eingang des Vergleichers 1c und am unteren (+) Eingang des Vergleichers 1d. Hierdurch schaltet der Vergleicher 1c die an ihm anliegende Masse vom Anschluß 3 auf die Sicherheitslampe 1a (bzw. 1b) durch und durch deren Aufleuchten wird der Fahrer gewarnt.

Bricht die Verbindungsleitung 6 zwischen dem Steuergerät 5 und dem Block 1, dann ändern sich ebenfalls die unteren Eingangsspannungen der Vergleicher 1c und 1d. Jetzt schaltet ebenfalls der Vergleicher 1c durch und legt Masse 3 an die Warneinrichtung 1a bzw. 1b.

Der Vergleicher 1c sorgt somit für ein Anschalten der Warneinrichtungen 1a bzw. 1b in einem unvorhergesehenen Fehlerfalle (Drahtbruch von 6 bzw. 4).

Im fehlerfreien Zustand des Steuergeräts 5 bzw. der Verbindungsleitungen 4 bzw. 6 stellt sich über die Spannungsteilerwiderstände 1h und 5a an den Vergleichern 1c und 1d ein Spannungspotential ein, das keinen der beiden zum Anschalten der Warneinrichtungen 1a bzw. 1b veranlaßt (normaler Betriebszustand).

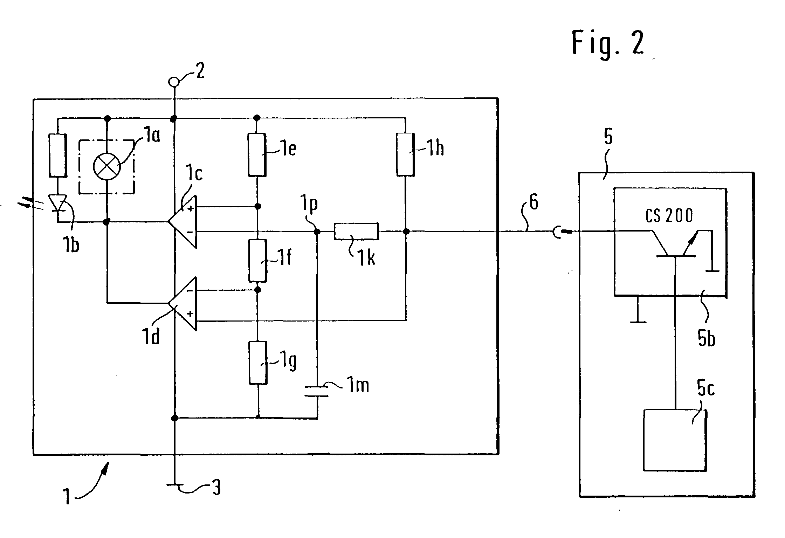

In Figur 2 ist ein Ausführungsbeispiel der erfindungsgemäßen Einrichtung dargestellt. Entsprechende Elemente wie in Figur 1 sind mit gleichen Bezugszeichen bezeichnet. Gegenüber der Figur 1 entfällt der Widerstand 5a. Zusätzlich enthält das Steuergerät einen Mikroprozessor 5c, der den Schalter 5b im Steuergerät ansteuert.

Der negative Eingang des Vergleichers 1c steht über einem Punkt 1p und einem Widerstand 1k mit dem Steuergerät 5 in Verbindung. Der Punkt 1p steht Desweiteren über einem Kondensator 1m mit Masse in Verbindung.

Der Mikroprozessor 5c steuert über den Endstufenschalter 5b die Sicherheitslampe 1a oder 1b mit einem pulsweitenmodulierten Signal an. Durch Integration über den Widerstand 1k und den Kondensator 1m bildet sich am Punkt 1p ein mittlerer Spannungswert aus. Die Vergleicher 1c und 1d vergleichen diesen Spannungswert mit dem vom Spannungsteiler, bestehend aus den Widerständen 1e, 1f und 1g, bereitgestellten Vergleichswert.

Im wesentlichen stellt die Reihenschaltung aus Widerstand 1h, 1k und dem Kondensator 1m ein Spannungsteiler für das pulsweitenmodulierte Signal dar, der an den Spannungsteiler bestehend aus den Widerständen 1h und 5b bei Figur 1 ersetzt.

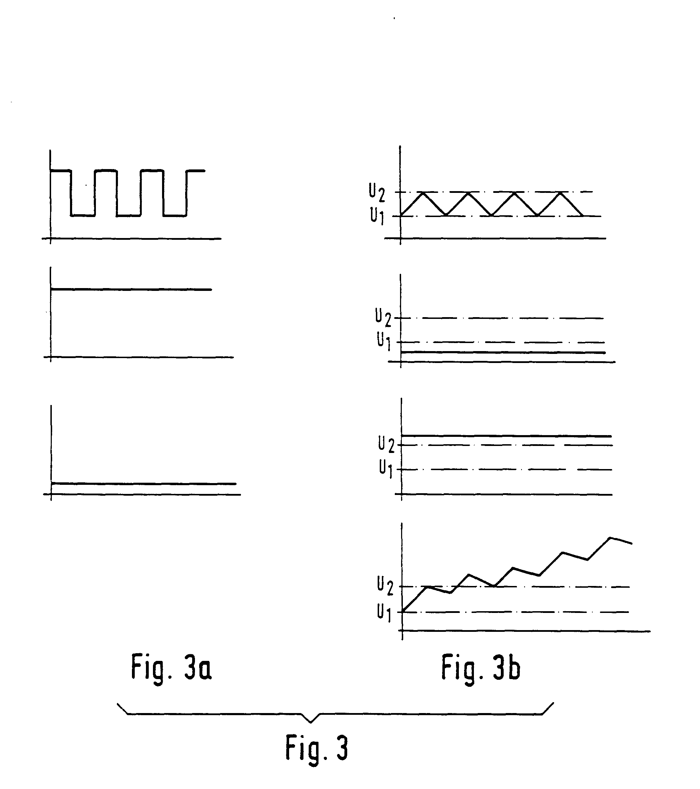

In Figur 3 sind verschiedene Signalverläufe dieser Anordnung dargestellt. In Figur 3a ist das Ausgangssignal des Mikroprozessors 5c das über die Verbindungsleitung 6 zum Block 1 übertragen wird. In Figur 3b ist das Potential am Punkt 1p gegen Masse aufgetragen.

In der ersten Zeile der Figur 3a ist der ordnungsgemäße Betrieb des Steuergeräts dargestellt. Dies bedeutet, das Signal schwankt zwischen einem ersten und einem zweiten Wert. Dies hat zur Folge, daß wie in der ersten Zeile der Figur 3b dargestellt, das Potential am Punkt 1p zwischen einem ersten Wert U1 und einem zweiten Wert U2 schwankt. In diesem Zustand sprechen die Vergleicher 1c und 1d nicht an.

Die Warneinrichtung 1a bzw. 1b sind nicht mit Masse 3 verbunden.

Gibt der Mikroprozessor 5c ständig einen hohen Signalpegel ab bzw. wird der Schalter 5b ständig durchgesteuert, so führt dies dazu, daß am Punkt 1p eine Spannung anliegt, die ständig unter dem ersten Wert U1 liegt. Wird dagegen der Schalter 5b ständig offen gehalten, wie es in Figur 3A in der dritten Zeile dargestellt ist, so bildet sich am Punkt 1p eine Spannung aus, die ständig über dem zweiten Spannungs-Wert U2 liegt. In diesen beiden Fällen liegt die Spannung am Punkt 1p außerhalb des zulässigen Bereichs, das bedeutet, daß der Vergleicher 1c den Stromfluß durch die Warneinrichtung 1a bzw. 1b freigibt.

Tritt ein Fehler, insbesondere im Steuergerät auf, bei dem ein getakteter Betrieb vorliegt, die Spannung am Punkt 1p aber ständig ansteigt oder abfällt, so wird die Warneinrichtung 1a bzw. 1b ebenfalls derart angesteuert, daß sie leuchtet.

Vorteilhaft an der erfindungsgemäßen Ausführungsform ist es, daß bei reduziertem Schaltungsaufwand im Steuergerät 5 alle Vorteile der Anordnung nach Figur 1 bestehen bleiben. So können mit der erfindungsgemäßen Ausführungsform die selben Fehler wie bei der Anordnung nach Figur 1 erkannt werden. Desweiteren ist diese Schaltungsanordnung kurzschlußfest und verpolsicher, da lediglich eine Leitung zwischen Steuergerät und Signallampe erforderlich ist. Desweiteren kann dem Fahrer angezeigt werden, daß das Steuergerät durch Überspannung abgeschaltet wird. Desweiteren ist diese Anordnung kompatibel zu den bisherigen Schaltungsanordnungen insbesondere zu der in Figur 1 dargestellten Schaltungsanordnung.

Besonders vorteilhaft ist es, daß ein pulsweitenmoduliertes signal zur Ansteuerung der Warneinrichtung verwendet werden kann.

## Patentansprüche

1. Vorrichtung, die eine Warneinrichtung (1a, 1b) ansteuert, wobei diese Vorrichtung einen in einem Fahrzeug mitgeführten Regler zur Beeinflussung des Bremsdrucks und/oder des Motormoments und/oder der Lenkung in Abhängigkeit vom Bewegungsverhalten der Fahrzeugräder und/oder des Fahrzeugs sowie ein Steuergerät (5) umfaßt,
wobei die Vorrichtung wenigstens einen Vergleicher (1c, 1d) umfaßt, an den einerseits eine Vergleichsspannung und andererseits eine weitere Spannung anlegbar ist
wobei der Vergleicher (1c, 1d) durchschaltet und die an ihm anliegende Masse (3) an die Warneinrichtung anlegt, wenn die weitere Spannung kleiner als eine erste Vergleichsspannung und/oder wenn die weitere Spannung größer als eine zweite Vergleichsspannung ist,
wobei die Vorrichtung einen ersten Spannungsteiler (1e, 1f, 1g) enthält, der die erste und/oder die zweite Vergleichsspannung vorgibt und einen zweiten Spannungsteilers, der zwei Widerstände (1h und 1k) sowie einen Kondensator (1m) umfaßt, die in Reihe zwischen der Versorgungsspannung und der Masse (3) geschaltet sind, und der die weitere Spannung vorgibt,
wobei das Steuergerät (5) den zweiten Spannungsteiler mit einem pulsweitenmodulierten Signal ansteuert
wobei das Steuergerät (5) dazu dient im Falle eines Fehlers im Regler den zweiten Spannungsteiler derart anzusteuern, dass der Vergleicher Masse (3) an die Warneinrichtung (1a, 1b) anlegt und damit den Fehler anzeigt.

2. Vorrichtung nach Anspruch 1 oder 2, **dadurch gekennzeichnet, daß** die Vergleichspannungen und die weitere Spannungen derart gewählt sind, daß die Vergleicher bei Abreißen des Masseanschluß des Steuergeräts (5), beim Bruch der Ansteuerleitung zwischen Steuergerät (5) und Vergleicher und/oder bei Bruch der Versorgungsleitungen des Steuergeräts durchschalten und die an ihnen anliegende Masse (3) an die Warneinrichtung anlegen.

3. Vorrichtung nach einem der vorherigen Ansprüche, **dadurch gekennzeichnet, daß** der erste Spannungsteiler drei Widerstände (1e, 1f, 1g) umfaßt, die in Reihe zwischen der Versorgungsspannung und der Masse (3) geschaltet sind.

4. Vorrichtung nach einem der vorherigen Ansprüche, **dadurch gekennzeichnet, daß** die Spannungsteiler und/oder die Vergleicher in der Nähe der Warneinrichtung angeordnet sind.

5. Vorrichtung nach einem der vorherigen Ansprüche, **dadurch gekennzeichnet, daß** die Warneinrichtung im Sichtfeld des Fahrers angeordnet ist.

## Claims

1. Device which drives a warning apparatus (1a, 1b), this device comprising a regulator, carried in a vehicle, for influencing the brake pressure and/or the engine torque and/or the steering as a function of the movement behaviour of the vehicle wheels and/or of the vehicle, and a control unit (5),
the device comprising at least one comparator (1c, 1d) to which, on the one hand, a comparison voltage and, on the other hand, a further voltage can be applied,
the comparator (1c, 1d) making a through connection and applying the earth potential (3) applied to it to the warning device if the further voltage is lower than a first comparison voltage and/or if the further voltage is higher than a second comparison voltage,
the device containing a first voltage divider (1e, 1f, 1g) which predefines the first and/or the second comparison voltages, and a second voltage divider which comprises two resistors (1h and 1k) as well as a capacitor (1m) which are connected in series between the supply voltage and the earth potential (3), which second voltage divider predefines the further voltage,
the control unit (5) driving the second voltage divider with a pulse-width-modulated signal,
the control unit (5) serving, in the case of a fault in the regulator, to drive the second voltage divider in such a way that the comparator applies the earth potential (3) to the warning apparatus (1a, 1b) and thus indicates the fault.

2. Device according to Claim 1 or 2, **characterized in that** the comparison voltages and the further voltages are selected in such a way that if the earth potential connection of the control unit (5) is pulled off, or if there is a break in the drive line between the control unit (5) and the comparators and/or in the supply lines of the control unit, the comparators make a through connection and apply the earth potential (3) applied to them to the warning apparatus.

3. Device according to one of the preceding claims, **characterized in that** the first voltage divider comprises three resistors (1e, 1f, 1g) which are connected in series between the supply voltage and the earth potential (3).

4. Device according to one of the preceding claims, **characterized in that** the voltage dividers and/or the comparators are arranged in the vicinity of the warning apparatus.

5. Device according to one of the preceding claims, **characterized in that** the warning apparatus is arranged in the driver's field of vision.

## Revendications

1. Dispositif déclenchant un système de détresse (1a, 1b) comprenant :
- un régulateur embarqué dans le véhicule pour influencer la pression de frein et/ou le couple moteur et/ou la direction selon le comportement de déplacement des roues du véhicule et/ou du véhicule ainsi qu'un appareil de commande (5),
- au moins un comparateur (1c, 1d) recevant d'un côté une tension de comparaison et de l'autre une autre tension, le comparateur (1c, 1d) commutant et appliquant à l'installation de détresse la masse (3) à laquelle il est relié, si l'autre tension est inférieure à une première tension de comparaison et/ou si l'autre tension est supérieure à une seconde tension de comparaison,
- un premier diviseur de tension (1e, 1f, 1g) qui prédéfinit la première et/ou la seconde tension de comparaison ainsi qu'un second diviseur de tension comprenant deux résistances (1h, 1k) et un condensateur (1m) branchés en série entre la tension d'alimentation et la masse (3) et qui prédéfinit l'autre tension,
dispositif dans lequel l'appareil de commande (5) commande le second diviseur de tension avec un signal à modulation de largeur d'impulsion, et cet appareil de commande (5), en cas de défaut dans le régulateur, sert à commander le second diviseur de tension, pour que le comparateur mette l'installation de détresse (1a, 1b) à la masse (3) et indique ainsi le défaut.

2. Dispositif selon la revendication 1,
**caractérisé en ce que**
les tensions de comparaison et les autres tensions sont choisies pour qu'en cas de rupture du branchement de la masse de l'appareil de commande (5), de rupture de la ligne de commande entre l'appareil de commande (5) et le comparateur et/ou en cas de rupture des lignes d'alimentation de l'appareil de commande, les comparateurs se ferment et appliquent, la masse (3) à laquelle ils sont mis, à l'installation de détresse.

3. Dispositif selon l'une des revendications précédentes,
**caractérisé en ce que**
le premier diviseur de tension comprend trois résistances (1e, 1f, 1g) branchées en série entre la tension d'alimentation et la masse (3).

4. Dispositif selon l'une des revendications précédentes,
**caractérisé en ce que**
les diviseurs de tension et/ou les comparateurs sont à proximité de l'installation de détresse.

5. Dispositif selon l'une des revendications précédentes,
**caractérisé en ce que**
l'installation de détresse se trouve dans le champ de vision du conducteur.
